# EUROPEAN PATENT APPLICATION

(11) **EP 1 906 058 A2**
(43) Date of publication of application: **02.04.2008**
(21) Application number: 07380188.8
(22) Date of filing: 27.06.2007
(51) Int. Cl.: F16H 61/00, H05K 5/02

(54) **Method and device for the production of boxes for electrical control gear**

(30) Priority: 27.07.2006 ES 200602017
(71) Applicant: Fabricacion de Material Electrico, S.A., 08110 Montcada I Reixac Barcelona (ES)
(72) Inventor: Latre Navarro, Carlos José, 08110 Montcada I Reixac (Barcelona) (ES)
(74) Representative: Durán Moya, Luis-Alfonso

(57) **Abstract**

A method and device for the manufacture of boxes for electrical control gear, of the type of control gear boxes which comprise at least one power socket located in the front part of the box which comprises steps of placing in display means displays corresponding to a frame of the box and to the power sockets, with subsequent steps of generation of a document of elements which contains the physical data of the elements displayed, prior to the assembly of the box from the element document.

## Description

The present invention relates to a method and a device for the production of boxes for electrical control gear.

The boxes produced according to the method of the present invention will be dedicated especially to receiving connection sockets for external apparatuses, as well as other elements and their corresponding magnetothermic devices.

Each electrical installation has its own characteristics, which result in specific requirements for a box or boxes for control gear that are significantly different from one installation to another. These variations result in the need for different types of sockets and other elements which differ with regard to their dimensions and structure, especially in the form of fixing. Given the difficulty of customising the boxes in an initial phase of production of components, this has forced the installer or the manufacturer of the boxes to carry out additional steps of customised manufacture in which an initially manufactured standard box was altered, for example by adding to it new holes for screw fixing, breaking certain elements, etc., with the consequent additional cost and lack of a clean and safe finish.

The document ES2214159 of the present inventor disclosed electrical control gear boxes of adaptable modular type which solve the problems associated with the lack of adaptation of the standard boxes to the additional process of customised manufacture, permitting the adaptation in the structure of the socket box and other elements with a wide variety of sizes and shapes.

In spite of the advance which this type of control gear boxes signified, the inventor observed that difficulties still arise in the additional process of customised production, in so far as errors of interpretation often occur which mean that the box produced does not meet the real needs of the client.

The conventional method of customised manufacture of control gear boxes is as follows:
a) firstly, a map document is produced of the whole electrical installation which contains the type of electrical elements to be contained into the box and the electrical connections between them;
b) where necessary, those safety elements to be contained in the box which are necessary for the safe use of the electrical installation are added;
c) from the map document, those "headline" elements/power sockets are selected which will be included in the electrical control gear box;
d) from the map document, each electrical or safety element is related to an electrical or safety element of standard type;
e) an assembly of boxes for electrical control gear is selected that is capable of containing the electrical and safety elements selected during step d);
f) the electrical and safety elements selected in step c) are then mounted on the box or boxes selected in step d) and they are then electrically connected to one another according to the requirements of the map document.

Conventionally, the map document has been produced by hand, on paper. In more recent times it is more usual to generate a digital type map document, which permits greater automation of the process which, however, has remained unaltered with regard to the main steps a) to f) described above. According to this method, the prior generation of the map document, which could be, for example, a section of the single wire diagram of the electrical installation, is fundamental and necessary for the customised production of these control gear boxes.

However, according to the research carried out by the inventor, it is precisely this step of generation of the map document which raises problems in the later steps of customised production.

A first problem lies in the fact that the installers (who are those customarily charged with determining the requirements of the electrical installation), since they are mainly field workers, are not at ease during the step of generating the map document. As a result, it is customary for errors to occur in the generation of same. For the same reason, it is also customary for the installers to leave the generation of the map document in the hands of the box manufacturer. In this latter case, errors due to omissions in the communication of requirements of the installation are also customary. Also, in certain cases, the installers select standard elements according to the step b) mentioned above, which may result in over-sizing of the box if the manufacturer has available standard elements which do not coincide with those initially used by the installer, with the consequent increase in price.

In order to provide a solution to the drawbacks described above, the present invention consists of a method of manufacture of boxes for electrical control gear, of the type of control gear box which comprises at least one power socket located in a front part of a box frame, which method is characterized in that it comprises the steps of:
a) providing a display zone in display means;
b) arranging in the display zone at least one representation corresponding to the front part of a frame of a control gear box, said representation corresponding to the physical dimensions of said front part;
c) for each power socket to be contained by the box:
   c1) selecting a power socket from a database, according to its characteristics;
   c2) arranging a representation of the front part of the selected power socket on a zone of the representation of the control gear box frame, the dimensions of said representation corresponding to those of the representation of the front part of the box;
d) arranging on the representation of the front part of the control gear box frame a representation corresponding to the front part of the safety elements associated with the selected power sockets;
e) generating a document of elements, which contains the physical data of the elements displayed in the display zone;
f) assembling the control gear box on the basis of the data of the document of elements.

Obviously, in order to carry out this method, it is implicitly necessary that the control gear boxes of standard type can accept power sockets of different types. Boxes of this type are already known, for example from the mentioned document ES2214159.

The tests carried out by the inventor showed that this method is much more intuitive for the installers than the methods of the state of the prior art, which required the generation of a map document or single-wire diagram of the installation, the result of which is minimisation of errors and omissions during the manufacturing process. For this it is necessary to have available a database which makes it possible to select the elements according to their physical characteristics. Another advantage of the present invention is that it makes it possible to generate a document for assembly of the box in which the elements to be fitted are already indicated, without giving the option of interpretations by the manufacturer/assembler which could lead to error. Finally, but no less importantly, the method of the present invention permits easy, complete and advantageous automation.

The document of elements generated in step e) mentioned above may easily contain an identifier for each of the prefabricated elements to be used in the assembly of the control gear box, thereby permitting easy and safe assembly of the control gear box from prefabricated or standard type elements. The generation of the document of elements also makes it possible, for example to send the document via a communications network, in such a way that the assembly of the box is carried out, for example, at a geographical location different from that of the work site, with the consequent saving in costs.

The method of the present invention also has the advantage of being more easily automated than the previously known methods, inasmuch as it allows the step of selection of a power socket from a database to be assisted by means of a search engine with access to the database of elements. Preferably, the search engine may carry out the following sub-steps within the method of the present invention:
c11) issuing an enquiry relating to a first property of the element to be selected, indicating the possible replies to the question or, in other words, the possible values of said first property;
c12) once the user has selected the value of the first property, that is to say, a reply to the question is received, the search engine searches, for the selected value, the possible values of a second characteristic of the element to be selected;
c13) the searcher issues an enquiry to the user relating to said second property, indicating the possible values of said second characteristic;
the process being repeated until the searcher finds a selected element.

Then, preferably, display means associated with the search engine may offer the user the representation of the front part of the aforesaid selected element.

The method of the present invention may also comprise the automatic generation of a document which contains data of the elements of the box, as well as the electrical connection existing between them. This document, although it has similar characteristics to the map document of the state of the art, is not however necessary for the manufacture of the control gear box according to the method of the present invention.

In a possible embodiment of the method of the present invention, electronic computing devices may be used, especially programmable type devices. This has significant advantages such as, for example, being able, during the step of display of the safety elements, to generate a file with the selected power sockets and the properties of each one. From said file and by means of programmable automatic means, it is possible to determine the number, type and characteristics of the safety elements to be fitted, with the consequent saving of time and avoiding errors due to lack of knowledge of the standard to be applied.

The display zone may be a zone within a screen controlled by electronic means such as, for example, the aforesaid programmable electronic means.

The present invention also comprises a device for carrying out the method according to the present invention. Said device, in a basic embodiment, may comprise:
- display means for arranging on a display zone representations corresponding to the front part of elements corresponding to the elements of a control gear box;
- means for generating a document of elements which contains the physical data of the elements represented in the display zone.

In preferred embodiments, the device may comprise a search engine with access to a database of elements for selection of power sockets of the box according to their properties, and means associated with the search engine to offer the user a display of the front part of the selected power socket. With regard to the database of elements, this may be comprised, for example, in an electronic memory of the device or be accessible via network means, for example. It may also comprise a screen controlled by electronic means. It may also comprise means for the automatic generation of a file which contains the selected power sockets and the properties of each one, as well as computing means for determining the number, type and characteristics of the safety elements to be fitted. The device may also comprise means for the automatic generation of an element file which contains the physical data of the elements finally represented in the display zone. The device may comprise a network connection and means for sending the aforesaid element file. Lastly, the device may also comprise programmable means which contain commands for executing steps a) to e) of the method of the present invention.

For better understanding of the invention, drawings of an embodiment of the present invention are appended by way of non-limiting example.

Figure 1 is a diagram which represents schematically a possible embodiment of the method of the present invention.

Figure 2 is a perspective view which represents, in use, a possible embodiment of the device of the present invention.

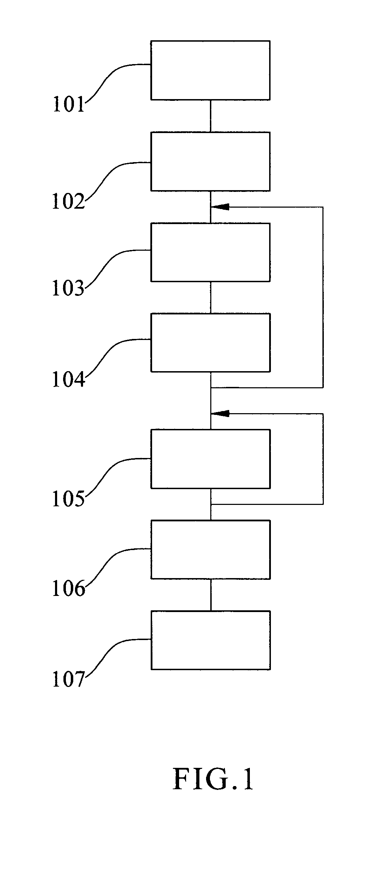

Figure 1 shows diagrammatically a possible embodiment of the method of the present invention.

The method of the present invention comprises a first step 101 in which a display zone is arranged in display means. Said display means may, for example, be a panel, preferably with pre-marked zones for facilitating the later fitting of elements. There may also be display means such as an electronic type screen on which can be represented a display zone suitable for carrying out the following steps.

The following step 102 comprises arranging in the display zone one or more representations corresponding to the front part of the frame of one or more control gear boxes. In order to achieve the effects of the invention, said representation should correspond, in its basic parameters, to the physical dimensions of the said front part. For this, the representation may be, for example, a graphic representation to scale of the front part of a frame of a control gear box. Logically, the control gear box represented should be of the type which makes it possible to position in its front part, in modular fashion, different types of elements and power sockets. The document ES2214159 describes boxes of this type.

In subsequent steps, the user must proceed to place, by means of the display means, the power sockets which the box should have. Since the method of the present invention does not require the prior creation of a map document, such as a single wire diagram, this requires a step 103 in which each power socket should be selected according to its characteristics, that is, selecting a standard element suitable for the function which it is to perform according to its characteristics. According to the research and tests carried out by the present inventor, this method of selecting a standard element according to its characteristics is much safer and has fewer failures than the previously known alternatives.

In order to make this selection, it is convenient to have available a database of standard elements (principally power sockets) that is structured according to their characteristics. This permits easier selection. As an alternative, or complementary thereto, it is possible to have available a search engine with access to said database of elements, such that the engine asks the user the value of a property (for example, the operating voltage) of the element to be selected, preferably by means of the indication of the possible values. Once the value of said property is received, the search engine selects a property of the power socket (for example, the degree of IP protection, etc.), selects the possible values of the second property for those elements of the database which comply with the value given for the first property, and again asks the user about the value of this second property, informing of the possible values thereof, the process being repeated until a standard power socket is found which meets the necessary specifications.

Once the standard power socket is selected, the user should have available in a later step 104 a representation of the front part of the selected power socket on the corresponding zone of the display of the frame of the control gear box. For this, it is necessary for the dimensions of said representation of the power socket to correspond to those of the frame.

In the particular case of the use of the search engine, the latter may advantageously offer the user the aforesaid representation, for example by means of its appearance on the display screen.

This process should be repeated as many times as is necessary, including in the display zone new representations corresponding to additional control gear box frames, if this should be necessary.

In the case of boxes which contain accessories, this process of selection and placing of representation of power sockets may be repeated with another type of element.

In particular, once the power sockets have been positioned, in a following step 105, there is then arranged on the representation of the front part of the control gear box frame a representation corresponding to the front part of the safety elements associated with the selected power sockets, which customarily have a specific position in the frame of the control gear box. This process is repeated as many times as is necessary. In particular, if the method is assisted by automatic and/or computing means, a file may be generated automatically having the selected power sockets and the properties of each one, and then, likewise automatically, the number, type and characteristics of the safety elements to be fitted may be determined.

Once the steps 101 to 105 have been carried out, a display of the components which will form the control gear box is available. From these data it is possible to generate, in a later step 106, a document of elements which contains the physical data of the elements represented. The document may for example be a text file with the data of the selected elements, or may be based on the display obtained previously, including element identifiers and/or the relevant physical data. In the case where the method is carried out with the assistance of automatic and/or computing means, this document could be generated automatically, including therein the data of the elements of the box and the electrical connection existing between them.

This document 106 may definitively be used so that the control gear box manufacturer, in a later step 107, manufactures a control gear box from elements, preferably standard, contained in said document, which he may receive, for example, via a communications network, such as, for example, an IP network.

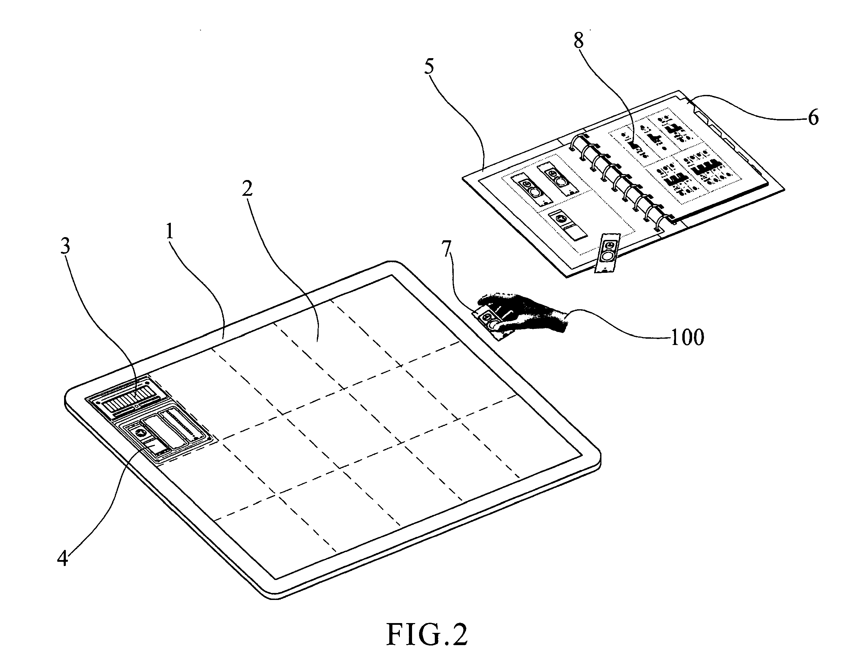

Figure 2 shows a device for carrying out the method of the present invention. The device shown is in a rudimentary form and, diagrammatically, coincides with that which was used by the inventor to carry out the tests for checking the advantages of the method of the present invention.

The arrangement shown comprises a display template 1 which comprises a display zone 2. The display zone has divisions for placing in an ordered manner representations 3 corresponding to front parts of standard type frames of control gear boxes. In the case shown in Figure 2, a graphic representation 3 of the front part of a control gear box frame has been displayed, corresponding to the type of control gear box disclosed in the document ES2214159, which has the advantage of being able to receive multiple power sockets of standard type.

In order to carry out the method of the present invention, booklets 5 are provided in which removable adhesive graphic representations 4, 7, 8, of power sockets have been arranged. The power sockets are arranged in order according to their characteristics, such that the user 100 had to search, firstly, for the value of a first property of the power socket and, within that value, for the value of a second property of the power socket, until a display of a power socket 4, 7, 8 is located. Once the power socket is selected, the user lifts the self-removable graphic representation and sticks it on to a corresponding spot of the representation 3 of the frame of the box. The displays 4, 7, 8 incorporate a reference number. The safety items are then likewise dealt with. Once affixed to the representation of the frame 4, these constitute a document containing the physical data of the elements represented, from which document a control gear box may be manufactured.

The display shown in Figure 2 is very basic, but well illustrates the additional advantages which can be obtained by the use of devices which comprise automatic means for assisting the implementation of the method of the present invention.

For example, it may be advantageous to substitute the display template 1 shown, with a screen controlled by electronic means. Said screen may belong to a programmable electronic device or to a printed circuit electronic device especially dedicated to the present application, for example.

As indicated previously, a device for carrying out the method of the present invention may advantageously include a search engine with access to a database of elements for selection of power sockets according to the properties of same, and also means associated with the search engine for offering the user, for example on screen, a display of the front part of the selected power socket. For the purpose of storage and availability of the database, the device will comprise an electronic memory.

Another advantage of using a device which contains electronic type automatic elements is that this may comprise the means necessary for automatically generating the aforesaid document of elements, which contains the physical data of the elements finally represented in the display zone of the screen.

In the case of use of a device which comprises programmable means, this may advantageously contain the precise commands for carrying out steps a) to e) of the method according to any one of claims 1 to 9.

Although the invention has been described with respect to preferred exemplary embodiments, these should not be regarded as limiting the invention, which will be defined by the widest interpretation of the following claims.

## Claims

1. A method of manufacture of boxes for electrical control gear, of the type of a control gear box which comprises at least one power socket located in a front part of a box frame, which is **characterized in that** it comprises the steps of:
a) providing a display zone in display means;
b) arranging in the display zone at least one representation corresponding to the front part of a frame of a control gear box, said representation corresponding to the physical dimensions of said front part;
c) for each power socket to be contained by the box:
c1) selecting a power socket from a database, according to its characteristics;
c2) arranging a representation of the front part of the selected power socket on a zone of the representation of the control gear box frame, the dimensions of said representation corresponding to those of the representation of the front part of the box;
d) arranging on the representation of the front part of the control gear box frame a representation corresponding to the front part of the safety elements associated with the selected power sockets;
e) generating a document of elements, which contains the physical data of the elements displayed in the display zone;
f) assembling the control gear box on the basis of the document of elements.

2. A method according to claim 1, **characterized in that** the document of elements that is generated comprises an identifier of each of the prefabricated elements to be used in the assembly of the control gear box.

3. A method according to claim 1 or claim 2, **characterized in that** the step c1) is carried out by means of a search engine with access to a database of elements, the search comprising the following sub-steps:
c11) the engine issues an enquiry to the user relating to a first property of the element to be selected, indicating the possible replies or values of said first property;
c12) once a reply has been received, the engine searches, for the value of said first property, the possible values of a second property of the element to be selected;
c13) the searcher issues an enquiry to the user relating to said second property of the element to be selected, indicating the possible values of said second property;
the process being repeated until the searcher finds a selected element.

4. A method according to claim 3, wherein display means associated with the search engine offer the user the aforesaid display of the front part of the element selected.

5. A method according to claim 4, **characterized in that** the aforesaid display means comprise a screen controlled by electronic means.

6. A method according to any one of claims 1 to 5, **characterized in that** step d) comprises the generation of a file with the selected power sockets and the properties of each one and the determination by automatic means of the number, type and characteristics of the safety elements to be fitted.

7. A method according to any one of claims 1 to 6, **characterized in that** it comprises a step of sending the aforesaid document of elements via a communications network.

8. A method according to any one of claims 1 to 7, **characterized in that**, as well as for the power sockets, steps c) and d) also apply to other accessories to be contained by the box.

9. A method according to any one of claims 1 to 8, **characterized in that** it comprises the automatic generation of a document which contains data of the elements of the box and the electrical connection existing between them.

10. A device for carrying out a method according to any one of claims 1 to 9, **characterized in that** it comprises:
- display means for arranging on a display zone representations corresponding to the front part of elements corresponding to the elements of a control gear box;
- means for generating a document of elements which contains the physical data of the elements displayed in the display zone.

11. A device according to claim 10, **characterized in that** it comprises a search engine with access to a database of elements, for selection of power sockets of the box according to their properties, and means associated with the search engine for offering to the user a display of the front part of the selected power socket.

12. A device according to claim 10 or claim 11, **characterized in that** it comprises an electronic memory with a database of elements.

13. A device according to any one of claims 10 to 12, **characterized in that** the display means comprise a screen controlled by electronic means.

14. A device according to any one of claims 10 to 13, **characterized in that** it comprises means for automatic generation of a file which contains the selected power sockets and the properties of each one, and also computing means for determining the number, type and characteristics of the safety elements to be fitted.

15. A device according to any one of claims 10 to 14, **characterized in that** it comprises means for generating a document of elements which contains the physical data of the elements finally displayed in the display zone.

16. A device according to any one of claims 10 to 15, **characterized in that** it comprises programmable means which contain commands for carrying out steps a) to e) of the method according to any one of claims 1 to 9.
